Europäisches Patentamt

(19) European Patent Office

Office européen des brevets

(11) Publication number: **0 376 967 B1**

(12) **EUROPEAN PATENT SPECIFICATION**

(45) Date of publication of patent specification: **14.07.93**  (51) Int. Cl.⁵: **G01R  31/36**

(21) Application number: **88906984.5**

(22) Date of filing: **01.08.88**

(86) International application number:
**PCT/GB88/00637**

(87) International publication number:
**WO 89/01169 (09.02.89  89/04)**

(54) **BATTERY STATE OF CHARGE INDICATOR.**

(30) Priority: **01.08.87 GB 8718280**

(43) Date of publication of application:
**11.07.90 Bulletin  90/28**

(45) Publication of the grant of the patent:
**14.07.93 Bulletin  93/28**

(84) Designated Contracting States:
**BE DE FR GB IT NL SE**

(56) References cited:
**EP-A-02 251 06**
**GB-A- 2 175 700**
**US-A- 4 390 841**

(73) Proprietor: **FORD MOTOR COMPANY LIMITED**
**Eagle Way**
**Brentwood Essex CM13 3BW(GB)**

(84) Designated Contracting States:
**BE GB IT NL SE**

(73) Proprietor: **FORD-WERKE AKTIENGESELL-**
**SCHAFT**
**Ottoplatz 2 Postfach 21 03 69**

**W-5000 Köln 21(DE)**

(84) Designated Contracting States:
**DE**

(73) Proprietor: **FORD FRANCE S. A.**
**B.P. 307**
**F-92506 Rueil-Malmaison Cédex(FR)**

(84) Designated Contracting States:
**FR**

(72) Inventor: **STEFFENS, Willi**
**Jagerstrasse 17-19**
**W-5100 Aachen(DE)**

(74) Representative: **Messulam, Alec Moses et al**
**A. Messulam & Co. 24 Broadway**
**Leigh on Sea Essex SS9 1BN (GB)**

**EP 0 376 967 B1**

**Description**

The present invention is concerned with determining the state of charge of a vehicle starter battery.

State-of-charge indicators are used for the protection and monitoring of electrochemical storage batteries and their loads. Their function is to determine the instantaneous state of charge of the battery (lz) and to provide an indication of the withdrawable charge ($q_e$) remaining in the battery.

State-of-charge indicators are used with the batteries of electric road vehicles, industrial trucks, invalid vehicles, private and commercial vehicles and in leisure and hobby activities.

Hitherto, state-of-charge indicators for these applications have been in general unsuitable for starter batteries in vehicles with combustion engines because they do not deal adequately with the operating conditions to which starter batteries are subjected.

One of the reasons for this is the fact that normally a starter battery is not used in cyclic operation (i.e. it is not subject to a regular cycle of charge, followed by discharge, followed by charge etc.) and over its life is approximately fully charged for most of the time. The accessories trade only offers voltmeters, sometimes with damping for taking a mean value, which frequently only make it possible to obtain an inexact indication of the state of charge of starter batteries.

For batteries used in cyclic operation a reliable state-of-charge indicator will take into account the charge withdrawn and the charge supplied. This method is only of limited application with regard to starter batteries because the charges withdrawn are normally small, the current dynamics are considerable and, due to many years of operation, the error in the charge measurement constantly increases, if no provision is made to reset it. The starting currents amount to more than 200 A, whereas the normal discharge current is below 30 A. It is necessary here to take other criteria such as temperature, discharge current intensity and off-load voltage into consideration in order to obtain a reasonable indication of the state of charge over a period of years.

Because of the complexity of determining the condition of the battery and the relatively high costs of hardware to handle such complex determinations, the use of state-of-charge indicators in a car would have been inconceivable until a few years ago - especially since, if properly looked after, batteries usually perform reliably for a period of several years.

In the last few years, however, the demands on the efficiency and reliability of starter batteries have increased due to the greater use of electronics and electric auxiliaries such as for example anti-lock systems, electronic injection, in-car computers, window winders, seat adjustment etc. Because some of these loads are for the road safety of the vehicle, it is essential to avoid too low a state of charge of the battery. Another aspect arises out of the losses of the generator during the charging process which also occur when the battery is already fully charged. Power losses of more than 1 kW could be saved if the generator were uncoupled from the engine when the battery is in a fully charged condition. The state-of-charge indicator could effect this disconnection. Also, the current which is constantly required while the vehicle is at rest to maintain the clock, in-car computer etc. in operation has increased in some cases to 100 mA. Consequently, monitoring of the condition of the battery is necessary where relatively long idle periods occur.

With the falling prices of digital circuits and the increased use of computers in motor vehicles, the use of state-of-charge indicators would now - for the reasons given above - appear to be a sensible and feasible idea.

An example of a state of charge indicator suitable for cyclic operation is described in US-A-4,390,841. A battery mathematical model forms the basis for making a capacity prediction from measurements of the discharge current and stored battery parameters. Self calibration to take account of changing battery characteristics due to ageing and charge/discharge history is effected by comparing predicted battery voltage with actual battery voltage and correcting the mathematical model accordingly.

The present invention uses an improved mathematical model which takes account of the gassing current ($i_g$) within the battery. This is particularly important for starter battery applications since a significant proportion of the stored charge may be discharged in the form of a gassing current $i_g$ in addition to the external current i drawn from the battery.

According to the present invention, there is provided a battery state of charge indicator for a vehicle starter battery including:

a) means for periodically measuring the output voltage (u), the current (i) being withdrawn from or supplied to the battery, and the temperature ($\theta$) of the battery,

b) battery current integrating means for integrating the battery current (i) with respect to time to produce an indication of the net charge (q) taken from the battery;

2

c) means responsive to successive measured values of battery voltage (u), current (i) and temperature ($\theta$) and to the net charge (q) taken from the battery to predict the net charge ($q_e$) which can still be withdrawn from the battery;

characterised by:

d) means for generating an indication of the gassing current ($i_g$) flowing inside the battery from the battery current (i); and

e) means for adding the gassing current ($i_g$) to the battery current (i) prior to integration thereof to correct for the effect of gassing current in the indication of withdrawn charge (q) taken from the battery and hence in the withdrawable charge ($q_e$) which can still be withdrawn from the battery.

The invention will now be described further, by way of example, with reference to the accompanying drawings, in which :

Figure 1 is the equivalent circuit diagram of a lead acid battery;

Figure 2 is a simplified equivalent circuit diagram of a lead-acid battery;

Figure 3 is the equivalent circuit diagram of a lead- acid battery in the overcharged range;

Figure 4 illustrates the division of the battery model into linear and non-linear components;

Figure 5 is a block circuit diagram of the Kalman filter structure;

Figure 6 shows the current voltage characteristic of the penetration voltage;

Figure 7 is a graph showing curves of i, $i_l$, and $i_g$ as functions of charge q for a new battery, q = 0 representing the beginning of the overcharging phase;

Figure 8 is a similar graph to that shown in Figure 7 except that the curves are for a 4 year old battery, q = 0 again representing the beginning of the overcharging phase;

Figure 9 is a graph showing the variation of withdrawable charge $q_e$ with discharge current i;

Figure 10 is a graph showing the variation of withdrawable charge $q_e$ with temperature $\theta$ at a number of different discharge currents i;

Figure 11 is a graph showing the state of charge lz, battery current i and withdrawable charge $q_e$ versus time for an urban trip under load at -20°C;

Figure 12 is a block circuit diagram of the battery state of charge indicator of the invention.

Numerals contained between square brackets in the following description are references to publication listed in the bibliography contained at the end of the description.

## 1. Definitions and quantities [1, 2]

Characteristic quantities of a battery are the rated voltage and the rated charge which is normally referred to by battery manufacturers as the rated capacity or rating. In a lead-acid battery the rated voltage $U_n$ is a multiple of the single-cell voltage of 2V.

In this specification lower case letters are used to refer to battery quantities relative to a nominal value so that for example:

$$u = U/U_n$$

This is done for convenience and the use of lower case letters in the claims should not be taken to be limitative to the use of relative rather than absolute values.

The withdrawable charge $q_e$ is the charge which can be withdrawn before the terminal voltage of the battery falls below the discharge cut-off voltage and is hence a measure of the storage capacity of the battery [3].

It should also be mentioned that the generator counting arrow system (EZS) is used to describe the electrical quantities of the battery. The charge released and the discharge current are counted positively.

## 2. Estimation of the battery condition

For starter batteries the off-load voltage $u_o$ and ohmic resistance r can be used to determine the state of charge. The off-load voltage, of course, is not present until after the battery has been at rest for several hours. In order that the off-load voltage can be estimated during the operation of the battery, a dynamic mathematical model of the battery is used.

For the purpose of estimating the off-load voltage and other battery characteristics that cannot be directly measured during operation the Kalman filter method is used. This method was first derived by R.E. Kalman as a generalisation of the Gaussian least-squares method. It uses a dynamic model of the observed process and also takes into account statistical properties which describe the accuracy of the measurements carried out on the system and the agreement between model and reality. A higher accuracy is obtained than with a low pass filter or a simple observer.

This method is, of course, rather complex even for simple systems. The cost of implementing it using analogue techniques would be virtually prohibitive. But the rapid development of microcomputer techniques has now made it possible with the support of an appropriate high-level language to implement a solution to this problem on single-board computers. This means that the unit can be built into a car.

2.1 Discrete battery model

**2.1.1 Equivalent circuit diagram of the lead-acid battery**

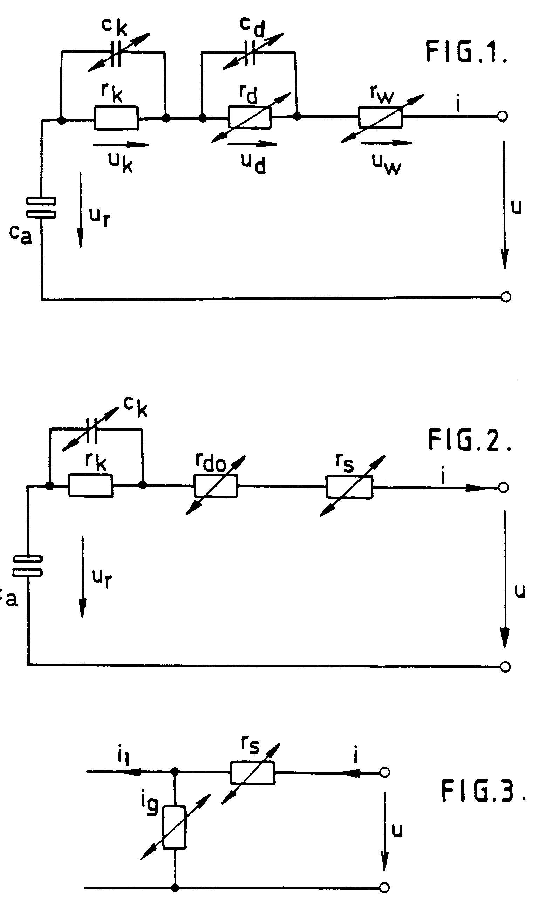

The basis used for the battery model of the embodiment of the present invention is the battery model by Runge [9] and Schleuter [8] as illustrated in Fig. 1.

The terminal voltage u is determined from the sum of the individual voltages.

$$u = u_r - u_w - u_d - u_k \qquad (2.1)$$

The off-load voltage $u_r$ of the battery is made up of the source voltage $u_o$ and the component $u_c$ which describes the change in the electrolyte concentration as a function of the charge removed.

$$u_r = u_o - u_c \qquad (2.2)$$

For $u_c$ the following relationship is applicable:

$$u_c = 1/c_a \int_0^t i \, dt \qquad (2.3)$$

In the model, the off-load voltage can be represented by an equivalent capacitance $c_a$ pre-charged to the source voltage $u_o$. This relative working capacitance $c_a$ describes the relationship between the withdrawn charge q and the off-load voltage $u_r$. The order of magnitude of this capacitance is in the megafarad range. For the relative quantity the values in the case of starter batteries are in the range of $c_a = 7$ to 10.

The value of this working capacitance is dependent only slightly on temperature and age. Because the relationship can be uniquely described and remains more or less independent of changing boundary conditions, the voltage $u_c$ is not corrected. However, in order to be able to determine fluctuations of the off-load voltage $u_r$ subsequently, the internal voltage $u_o$ of the battery is corrected by the filter.

For the description of the off-load voltage $u_r$ it is assumed that the voltage $u_c$ for the fully charged battery takes on the value zero. $u_o$ therefore represents the internal voltage of the fully charged cell in the rest condition.

In the case of the remaining voltages there are current-dependent voltage drops.

The voltage $u_d$ describes the behaviour when the charge carriers penetrate the electrical plate/acid double layer. The current-voltage characteristic is similar in this case to that of a diode [8]. At low currents the voltage drop increases quickly at first, but at high currents varies only a little. The relationship can be described by the following approximation formula according to Runge [9].

$$u_d = \text{sgn}(i).u_{do}.(1 - e^{-|i|/ido}) + r_{d1}.i \qquad (2.4)$$

This equation represents a good approximation of the Butler-Volmer equation which describes the penetration overvoltage. The use of this equation is permissible only in the discharge range and in the charging range up to the almost fully charged battery. With continuing charging the lead sulphate dissolves only at a slow rate. In this phase the gassing reaction and a number of other non-linear processes determine the course of the reaction.

The non-linear behaviour of the penetration voltage $u_d$ can be subdivided approximately into an ohmic and a non-linear component. The non-linear component is very largely independent of age and state of charge. The linear component from eq. (2.4) is allowed for in the filter model and approximately corrected. The non-linear component is described by the exponential function and is not taken into account in the filter.

The dynamic behaviour of the penetration polarisation is described by the capacitance $c_d$. The building-up and decay transients of this element are very much dependent on the current and are less than 30 seconds. No treatment takes place in the filter because the sampling cycle of one minute is greater than this time.

The concentration element, consisting of $r_k$ and $c_k$, describes the voltage on the basis of the differing concentration of acid in the pores of the plates and in the free acid volume. The acid density is equalised by means of the diffusion. The time constant for the equalisation of the acid density and the reduction in the overvoltage is of the order of 15-60 minutes and is different in the discharging and charging directions.

Because various chemical processes are superimposed on one another during charging, voltage layers are formed which are attributable to higher oxidation numbers. This retards the decay behaviour after charging. In particular, these overvoltages are highly dependent on temperature. The time constant approximately doubles when the temperature changes from $+20^{\circ}C$ to $0^{\circ}C$. The concentration resistance $r_k$ and therefore the height of the concentration voltage are scarcely dependent at all on the state of charge of the battery. At the start of discharge the value of the resistance falls somewhat initially[8], only to remain constant for most of the discharge process and rise again at the end. Mean values lie in the range from $r_k = 0.10$ to $0.15$.

The AC resistance $r_w$ contains the ohmic components of the voltage in the battery. This quantity can be determined by superimposing an alternating current on the direct current and measuring the falling alternating voltage [8]. It is also possible to load the battery with a stepped current and to calculate the resistance from the associated voltage variations.

If the mean values are taken of the measured values of voltage u and current i over a period of one minute and the Kalman filter is made to estimate a new state vector only every minute, the equivalent circuit diagram in Fig. 1 can be simplified. Because the time constant of the penetration element is now smaller than the sampling time, the penetration capacitance $c_d$ can be disregarded since all the associated decay and build-up transients are more or less terminated within the cycle time. From this we can derive a new simplified equivalent circuit diagram of the lead battery, as shown in Fig. 2.

The resistance $r_s$ combines resistances $r_w$ and $r_{dl}$ from equation (2.4). The non-linear component of the penetration element is simulated by the exponential function from equation (2.4).

In order to be able to describe the overcharge range as well, the battery model must be extended by a branch which describes the gassing reaction. The gassing branch of the model is described by the Tafel equation.

$$i_g = i_{go} \cdot e^{(u - u_{go})/kT} \tag{2.5}$$

The gassing current $i_g$ is very much dependent on age and temperature. The dependence on temperature can also be described by an exponential function.

$$i_{go}(\theta) = i_{go}(30^{\circ}C) \cdot e^{F \cdot (\theta - 30^{\circ}C)/K} \tag{2.6}$$

At the start of overcharging the voltage curve is marked by the superimposition of the charging and gassing reactions. In the case of high states of charge the curve is still determined only by the gassing reaction. In this phase the equivalent circuit diagram is reduced to the elements shown in Fig. 3.

The concentration element can be ignored because the charging currents have fallen to low values and thorough mixing of the electrolyte is brought about by the incipient gassing.

### 2.1.2 Discrete-time representation of the battery model

In order to be able to implement a Kalman filter [14,16,17], a model of the battery must be available which describes the terminal behaviour at discrete moments in phase space [18]. In order to be able to use a linear time-variant Kalman filter, the non-linear model components are separated, as in the foregoing section, and described as a constant system.

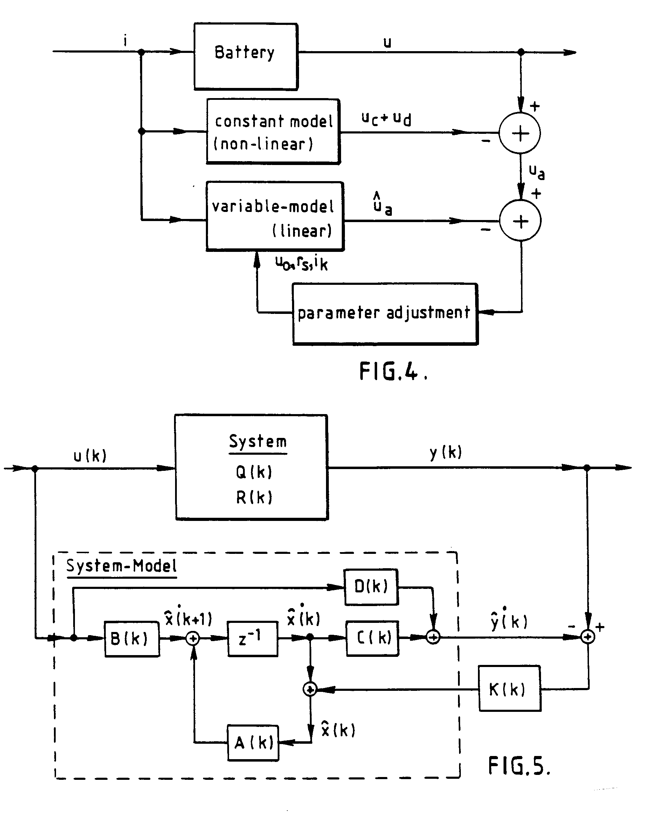

Fig. 4 illustrates the situation described.

### 2.1.2.1 Variable linear model component

The Kalman filter corrects the following four quantities in the battery model:

Internal voltage of the battery $\quad\quad\quad\quad\quad\quad$ : $u_o$

Current through the concentration resistance $r_k$ $\quad$ ; $i_k$

Ohmic resistance component of the battery $\quad\quad$ : $r_w$

Linear component of the diffusion resistance $\quad\quad$ : $r_{dl}$

The transformation into a discrete-time model is derived from the transfer equations of the continuous-time model.

For the concentration element the differential equation is as follows:

$$\frac{du_k}{dt} = -\frac{u_k}{r_k \cdot c_k} + \frac{i}{c_k} \qquad (2.7)$$

With the aid of the Laplace transform we obtain the transfer function in the complex variable domain. By inverse transform from the Laplace domain into the discrete-time domain we obtain the pulse response from which the z-transform of the output voltage is derived.

The difference equation for the concentration element is calculated from the inverse transform from the z-domain and is as follows:

$$u_k(k+1) = u_k(k).e^{-T/k} + i(k).r_k.(1 - e^{-T/rk}) \qquad (2.8)$$

with sampling time T and time constant $\tau_k$.

In this equation the concentration voltage $u_k$ is represented as a state variable. Because the resistance $r_k$ of the concentration element is taken to be constant, the current $i_k$ through the resistance $r_k$ is taken as the state vector instead of the voltage $u_k$. The difference equation is therefore divided by the resistance $r_k$ and from this the new difference equation for describing $i_k$ is obtained.

$$i_k(k+1) = i_k(k).e^{-T/rk} + i(k).(1 - e^{-T/rk}) \qquad (2.9)$$

The concentration voltage $u_k$ is then obtained from the subsequent multiplication by $r_k$.

$$u_k(k) = r_k.i_k(k) \qquad (2.10)$$

The time constant $\tau_k$ of the concentration element is varied as a function of temperature and current direction. In the discharge range and in the rest period after a discharge the time constant is:

$$\tau_k = 15 \text{ minutes} \qquad (2.11)$$

During charging and the subsequent rest period, the time constant is varied as a function of temperature. The following relationship is adopted in this case:

$$\tau_k = \tau_{k20} \cdot (1 + \frac{20^{\circ}C - \theta}{20^{\circ}C}) \qquad \text{with} \qquad (2.12)$$

$$\tau_{k20} = \tau_k(20^{\circ}C) = 60 \text{ minutes} \qquad (2.13)$$

6

For the other components the following equations of the continuous-time system are applicable:

$$u_o(t) = u_o \quad \text{internal voltage} \quad (2.14)$$

$$u_{d1}(t) = r_{d1}.i(t) \quad \text{linear component of the diffusion overvoltage} \quad (2.15)$$

$$u_w(t) = r_w . i(t) \quad \text{ohmic voltage drop} \quad (2.16)$$

To simplify the model, the ohmic resistance $r_w$ and the diffusion resistance $r_{dl}$ are combined into the total resistance $r_s$.

The voltage $u_s$ at the sum of the two resistances is:

$$u_s(t) = (r_{d1} + r_w).i(t) = r_s.i(t) \quad (2.17)$$

The corresponding equations for the discrete-time representation are:

$$u_o(k) = u_o \quad (2.18)$$

$$us(k) = r_s . i(k) \quad (2.19)$$

Because the resistance $r_s$ is strongly dependent on the age, state of charge and temperature of the battery, it would appear to be necessary to correct this value constantly in accordance with the changed boundary conditions. Because the filter is capable of estimating values of the state vector, the resistance $r_s$ is represented as a state variable. The same also applies to the internal voltage $u_o$. The difference equations for the state variables are:

$$r_s(k+1) = r_s(k) \quad (2.20)$$

$$u_o(k+1) = u_o(k) \quad (2.21)$$

In both cases a constant value is adopted for all times kT.

The voltage $u_s$ (k) is obtained by multiplication of the state vector element $r_s(k)$ by the time dependent parameter i(k).

From this is derived the state vector which contains the three elements $u_o$, $i_k$ and $r_s$.

The standard control form, the structure of which is illustrated in Figure 5, is used for the numerical description of the model.

### 2.1.2.2 Non-linear ans constant model components

This section described the non-linear components of the battery model which are not determined by the filter and the elements which are not estimated.

Three variables are described.

Non-linear characteristic of the penetration polarisation

Maximum value of the internal voltage $u_o$

Gassing current $i_g$ in the overcharging phase

### 2.1.2.2.1 Penetration polarisation

As already mentioned in section 2.1.1, the voltage $u_d$ atthe double layer is described according to eq. 2.4 by superimposition of a linear component and an exponential function. The linear component is already contained in the filter model. For the non-linear component, equation 2.22 was formulated.

$$u_d = u_{do}.(1 - e^{-i/i}do) \quad (2.22)$$

A limiting voltage of $u_{do} = 0.025$ and a threshold current of $i_{do} = 0.15$ were adopted for the starter batteries used. This approximation describes the penetration behaviour with sufficient accuracy.

Because, during the charging process used in the motor vehicle, a relatively low voltage limitation becomes effective when the fully charged state is reached, the charging currents decrease to values which for the most part lie in the non-linear region of the characteristic. Although a modified penetration characteristic is valid in this phase, the values of the two characteristics differ only very little for small charge currents.

The battery model adopted does not take into account the overcharging region. Because the battery is in a good state of charge anyway and the model description would appear much more complicated, only determination of the gassing current $i_g$ and monitoring of the terminal voltage u are carried out here and a precise description is abandoned.

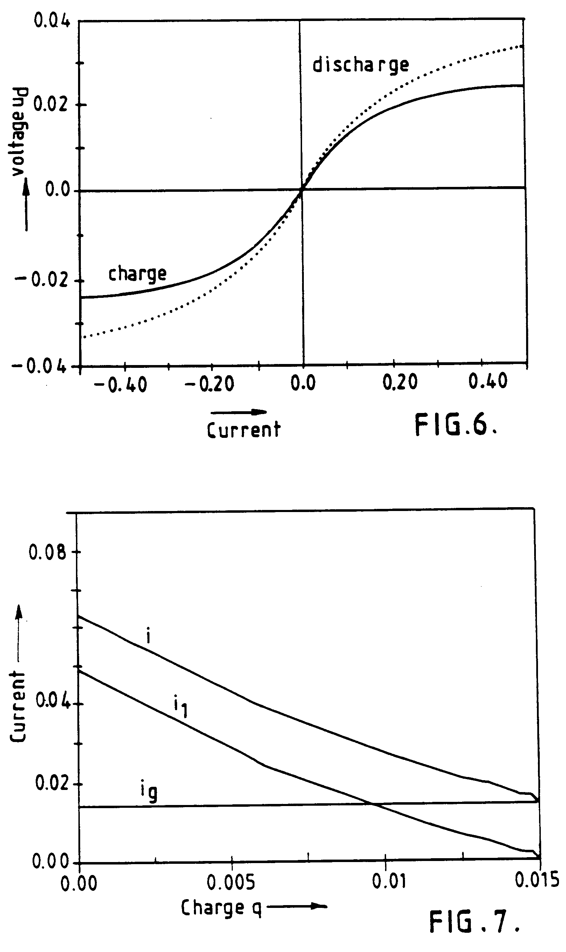

Figure 6 shows the graph of the current/voltage characateristic used. The dotted line is the graph of the penetration voltage according to eq. 2.4. The solid line represents the exponential function according to eq. 2.22.

### 2.1.2.2.2 Voltage limitation

Because of the voltage limitation during charging the charge current will decrease continuously and in the overcharging phase will ultimately become zero. In this phase, the voltage drops $u_k$, $u_s$ and $u_d$ of the model will disappear. There are then just the two voltages: the terminal voltage u and the internal voltage $u_o$.

If there is a difference between the two voltages, the Kalman filter attempts to minimise this error. The internal voltage is ultimately estimated at the value of the charge cut-off voltage. The internal voltage $u_o$ lies in the range from 1.03 to 1.1 depending on the age of the battery. The internal voltage $u_o$ will not therefore exceed this age-dependent maximum value in reality. In order to avoid the resulting error in the estimation of the internal voltage during charging, the value of $u_o$ islimited, when a maximum value $u_{omax}$ is exceeded, to $u_{omax}$.

Because the maximum voltage $u_{omax}$ falls with increasing age of the battery, the value of $u_{omax}$ must be continuously adjusted during operation. One possible solution is to compare the estimated off-load voltage $u_r$ at the start of a rest phase after a discharge with the actual end value of the off-load voltage $u_{re}$.

Because there are always non-working periods in vehicle operation, it is possible to measure the actual off-load voltage at the terminals of the battery. If this value of the off-load voltage $u_{re}$ is available, the formal relationship:

$$u_{re} = u_{onew} - q/c_a \qquad (2.23)$$

is valid for it. The value of the estimated off-load voltage $u_r$ immediately before the stabilisation is calculated using the same formula:

$$u_r = u_{oold} - q/c_a \qquad (2.24)$$

If the difference between the two voltages is obtained and the equation is solved for $u_{onew}$, a new improved value is obtained for $u_{omax}$.

$$u_{onew} = u_{oold} + (u_{re} - u_r) \qquad (2.25)$$

This new internal voltage $u_{onew}$ is used as a correction for $u_{omax}$. Because the difference between estimated and actual off-load voltages is reduced after correction, the error in the model estimation is decreased.

### 2.1.2.2.3 Estimation of the gassing current

The present model of the lead battery describes the battery behaviour with sufficient accuracy both in discharge operation and in charging operation up to the point of overcharge.

In overcharging phase an estimate is made of the gassing current $i_g$. The level of the gassing current $i_g$ is dependent to a large degree on temperature and age. Its magnitude represents a measure of the self-discharge of the battery and the water consumption during gassing. Because the overvoltage for hydrogen production decreases with age, values at some point fall below the usual charge cut-off voltage in the motor vehicle. If it is identifiable that the gassing current $i_g$ is rising, this effect can be reduced again by corresponding lowering of the charge cut-off voltage.

Because of the above aspects it is necessary to determine the gassing current $i_g$ of the battery, especially since existing measurement of the charge supplies in the overcharging phase provides incorrect values as the portion of the charge current which is required for gassing does not contribute to the increase in charge.

As explained in section 2.1.2, the behaviour during gassing is described by the Tafel equation. In this equation it is necessary to know the value of $i_{go}$ in order to calculate the gassing current $i_g$. However, because the value of $i_{go}$ is dependent on age, an attempt was made to estimate $i_g$ so that by monitoring $i_g$ and the constant voltage $u_{go}$ with allowance for the temperature it was possible to calculate the value of $i_{go}$.

If we take a new battery and observe its behaviour in the overcharging range when loaded with a constant voltage until a minimum charging end current is reached, this end value of the current can be adopted as the gassing current $i_g$ because in this phase the total current flowing in the battery is used for the gassing reaction. The value of $i_{go}$ can now be calculated using equations 2.5 and 2.6

Figure 7 illustrates the situation described. The charging current i is plotted against the actual charge supplied. The charging current comprises the current $i_l$ for the charging reaction and the current $i_g$ for the gassing reaction.

$$i = i_l + i_g \quad (2.26)$$

Because the charging voltage remains constant in this phase, there is also a constant value for the gassing current $i_g$ - as the figure shows. If the constant gassing current $i_g$ is subtracted from the total current i, the value of $i_l$ is obtained. The figure shows the curve for $i_l$ as being displaced parallel to the curve for the current i. In good approximation, the curve determined for the current $i_l$ can be considered not to be dependent on age. The curve of the current $i_l$ for a new battery plotted as a function of the charge q is stored in the computer with the aid of several support points and the intermediate values are approximated by a linear interpolation.

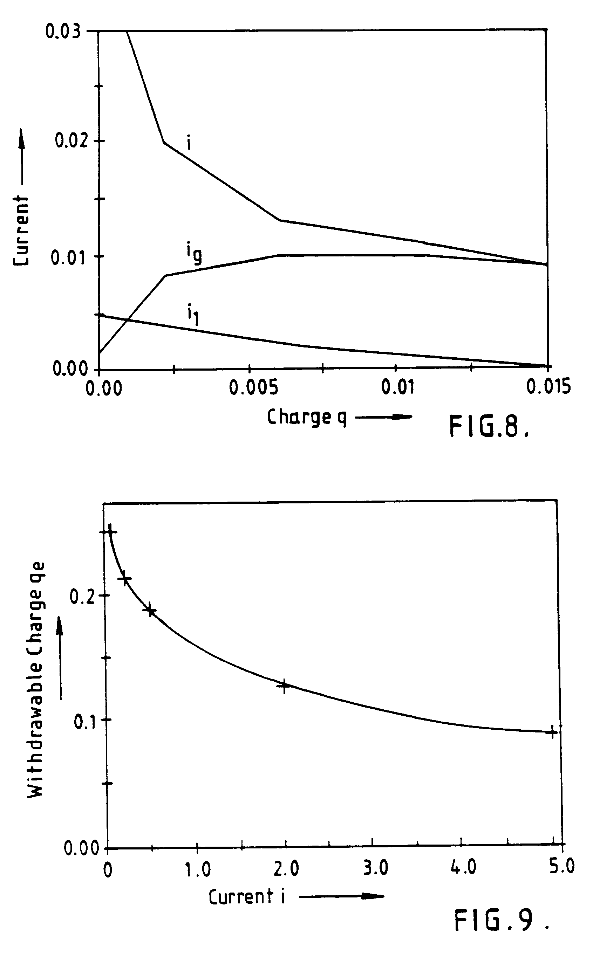

If a battery of any age reaches the overcharging phase, the age-independent current $i_l$ of the charger action is subtracted from the measured current i and the gassing current $i_g$ is obtained and from this it is then possible to calculate $i_{go}$. The charging current $i_l$ is used to calculate the charge q. As Fig. 8 shows, this method provides an indication of the gassing current $i_g$. The curve of $i_g$ shown in the figure for an old battery with high gassing current was estimated with the aid of the stored characteristic curve for the charging current $i_l$ which was determined on a new battery. Because the estimation of $i_g$ using the stored curve for $i_l$ may be very wrong at the beginning of the overcharging phase, the measured values of i are not involved very much initially in the estimation. The start value of the gassing current begins therefore at a value of $i_g$ such as is taken for a new battery and comes closer to the actual value of the gassing current $i_g$ as overcharging progresses.

## 3. Determination of the state of charge

In this section we explain a method of determining the state of charge using the internal quantities of the battery estimated by the Kalman filter.

### 3.1 Influences on the withdrawable charge.

The charge available at any one time from a lead storage battery depends on a number of influences. The main ones are the dependences on discharge current, temperature and age of the battery. However, the standing time after the last charge, the nature of the last charge and discharge also have an influence on the withdrawable charge $q_e$.

### 3.1.1 Influence of the discharge current.

The low diffusion rate of the electrolyte is the reason for the decrease in the withdrawable charge $q_e$ with increasing discharge current i.

Figure 9 shows the curve of the withdrawable charge $q_e$ plotted against the discharge current i. The withdrawable charge decreases noticeably with rising current intensity and in starter operation can fall to values of less than 40% of the rated charge $Q_n$ in a new battery. In the case of a 20-hour discharge at i = 0.05 the rated charge is removed by definition. These figures apply to 20°C electrolyte temperature.

When after a high-current discharge the discharge cut-off voltage is attained, the battery will be by no means fully discharged. In fact, after a relatively long off-load period the residual charge still present can be withdrawn by discharge with a small current.

The effect is caused by the fact that for the current to flow there is a transport of ions through the electrolyte. However, the ions can only diffuse at a definite rate which is dependent on the acid density. With high currents the ions can ultimately no longer be made available in sufficient numbers. The discharge

9

EP 0 376 967 B1

current which is then established results from the diffusion rate still available in the particular case.

When the starter battery was used in normal town traffic, peak values of the discharge current greater than $i = 0.2$ were rarely measured. Even under extreme conditions the maximum values were never greater than $i = 0.5$. The mean value of the discharge is, typically, $i \leq 0.2$ which represents a withdrawable charge of $q_e = 0.85$. The withdrawable charge varies therefore at the maximum between $0.75 \leq q_e \leq 1.0$ for a new battery. only the starter operation with currents of $i = 5.0$ represents another operating condition. Because normally this process rarely lasts longer than 10 seconds, the charge withdrawn ($\leq 0.002$) is negligibly small.

### 3.1.2 Influence of the temperature.

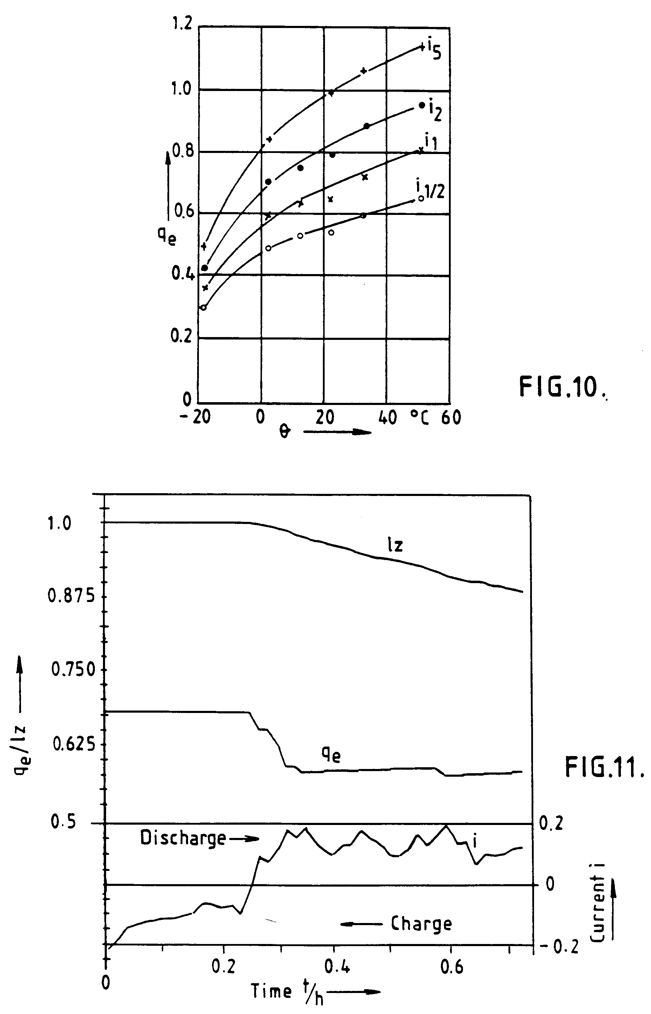

The temperature of the electrolyte has a considerable influence on the withdrawable charge $q_e$. As the temperature falls, the viscosity of the acid rises, the diffusion rate decreases and the ohmic resistance of the electrolyte rises. Figure 10 shows the influence of the electrolyte temperature on the withdrawable charge $q_e$ for different discharge currents [8]. Above freezing point there is a rise of approx. 0. 6%/K and below freezing point a rise of approx. 1.0%/K. If the withdrawable charge $q_e(\theta,i)$ is related to the withdrawable charge $q_e$ (30°C,i), this still results in only one curve in good approximation [4]. The temperature dependence, therefore, is very largely decoupled from the current dependence.

### 3.1.3 Influence of ageing.

Lead storage batteries, like any piece of engineering equipment, are subject to natural ageing which may be accelerated by incorrect handling. The main influence of ageing is to reduce the withdrawable charge as the result of material loss, corrosion of the grid plates, permanent sulphation and lead-coating [5,6,7,10,11].

Intensified loss of material occurs mainly due to the high starter current which causes the plates to move. Also, violent shaking is often the cause of sudden breakdown of the battery. Underneath the plates there is frequently no sludge space for crumbling pieces, therefore the material usually collects in the lower part of the plate. Because the plates are very close together for high energy utilisation, the separator ends up being very thin and can be destroyed by detached materials, resulting in local short-circuiting in the battery.

Corrosion of grid plates takes place mainly at the positive electrode due to the aggressive sulphuric acid. Intensified corrosion occurs especially in the fully charged state, at high temperatures and with too high charge cut-off voltages. Catalysts, including the antimony Sb of the grid alloy, also promote the corrosion process. The result of the corrosion is an increase in the volume of the positive plate and a reduction in the electro-conductive cross-section. Over a period of time this expansion results in flaking of the lead paste and can lead to short-circuits. Permanent sulphation and lead-coating reduce the surface of the plates causing a loss of capacitance. This process is accelerated by the failure to recharge partially or fully discharged cells immediately, by incomplete charging and by high acid concentrations.

All these variations have an influence on the withdrawable charge $q_e$ which, unfortunately, can only be partially determined in advance by measurement of voltage, current and temperature.

### 3.2 Determination of the withdrawable charge.

It has been shown in the preceding section that the withdrawable charge $q_e$ is essentially a function of discharge current i, temperature $\theta$ and age A.

$$q_e = f(i,\theta,A)$$

Typically, the current $i_{max}$ does not exceed 0.5 and the withdrawable charge $q_e$ is no less than 0.75. The curve is approximated by piecewise linearisation with four support points. The delayed variation of the withdrawable charge $q_e$ when the discharge current i is reduced is obtained by delaying the collection of current by means of a low-pass filter with a time constant of one hour.

If the age-dependent value of $q_{eo}(A)$ is available, the error that is still present is limited to deviations of the approximations of current and temperature valuation from the actual behaviour. The residual error remaining is less than 10%.

10

### 4. Functional description of estimation of battery condition

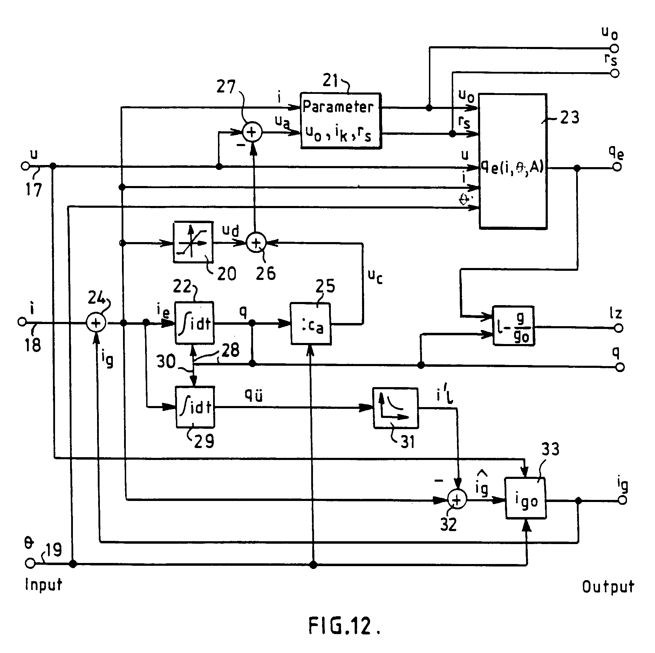

With the aid of block circuit diagram of Figure 12 we will explain in detail the functioning of the battery state of charge indicator of the present invention.

The input variables required are the battery current i, the battery voltage u and the electrolyte temperature $\theta$ on lines 17,18 and 19 respectively. The current i is used in battery current integrating means 22 to determine the charge q and in the Kalman filter 21 to estimate the condition of the battery and to estimate battery parameters indicative of the condition. It is used as an input variable of block 20 for the purpose of determining the non-linear components of the penetration voltage $u_d$. In block 23 the withdrawable charge $q_e$ is calculated from the battery current i, and the quantities $u_o$, $r_s$, u and $\theta$.

In order to accommodate the self-discharge and gassing, the current i is added at adder 24 to the voltage-dependent value of the gassing current $i_g$ and thus included in the charge calculation. The value of the withdrawn charge q is divided in block 25 by the temperature-dependent equivalent capacitance $c_a$ and gives the falling voltage $u_c$ at the capacitor. The sum of $u_c$ and $u_d$ is produced by adder 26 and subtracted by adder 27 from the battery voltage u. This difference voltage is used as a comparison value for the Kalman filter 21. The filter supplies the estimated values of the internal battery quantities $u_o$, $i_k$ and $r_s$. The charging current $i_l$ is included in block 22 only for positive values of q. If the charge q attains the value zero, it stops any further charge calculation via line 18 and starts via line 30, the calculation of the overcharge $q_u$ in overcharge current integrating means 29. The overcharge $q_u$ is supplied to block 31 where it is used to develop on estimated value $i'_l$ for the charging current based on a stored characteristic for the relationship between those quantities.

The estimated value of $i'_l$ is combined with measured i at the adder 32 to provide an estimation of the gassing current $\hat{i}_g$. From the value $\hat{i}_g$, block 33 calculates the value of $i_{go}$ and generates an indication of gassing current $i_g$ with allowance for temperature and voltage.

The state of charge Iz is calculated in block 34 taking into account withdrawable charge $q_e$ and withdrawn charge q. The internal voltage $u_o$, the resistance $r_s$, the withdrawn charge q, the withdrawable charge $q_e$, the state of charge Iz and the gassing current $i_g$ are indicated.

### 5. Summary.

The preferred embodiment of the present invention provides a battery state of charge indicator which includes means for the determination of the internal quantities of the battery.

The battery model is based on the elements of an equivalent circuit diagram with parameters which are fixed only for a particular operating situation. The parameters are continuously monitored and modified to take account of different operating conditions.

To monitor and modify the parameters, Kalman filtering is used. Because this is a linear estimator, but the elements have partially non-linear behaviour, the battery model is subdivided. The non-linear and constant elements are combined in a constant portion of the model, and only the linearly varying elements are contained in the filter model.

By means of this estimation of condition the system is capable of adapting to a particular battery and the operating situation applying at the time.

### 6. References

(1) DIN 40729, "Galvanic secondary cells (storage batteries). Definitions", Beuth-Verlag, Berlin, October 1975.

(2) DIN 72311, "Lead batteries. Storage batteries for starting, lighting and ignition. Testing". Beuth-Verlag, Berlin, May 1977.

(3) DIN 45539, "Lead batteries, vehicle drive cells and batteries." Part 3, Testing regulations (electrical and physical), Beuth-Verlag, Berlin, 1978.

(4) G. Wille, "Contribution to the determination of the energy consumption and residual range of electric road vehicles", Dissertation RWTH Aachen, 1983.

(5) G. Huster, "Life statistics of storage batteries", VARTA, aktuelle Batterieforschung, 1966.

(6) E. Voss, G. Huster, "Reliability of lead batteries", Chemie-Ingenieur-Technick, 38, pp.623-626 1966.

(7) T. Gerber, "Investigations of the life of tube-plate batteries for stationary operation", Technische Mitteilung PTT, 54, (6), pp.190-205,6/1976.

(8) W. Schleuter, "Description of the electrical behaviour of lead, nickel-cadmium and nickel-iron batteries", Dissertation RWTH Aachen, 1982.

(9) W. Runge, "Calculation and interpretation of the steady-state and dynamic behaviour of lead batteries", Dissertation RWTH Aachen, 1974.

(10) E. Voss, G. Huster, "The effect of depth of discharge on the cycle life of positive lead-acid plates", 29th AGARD-Meeting, Liege, pp. 57-72, 1967.

(11) F. Kretzschmar, "The diseases of lead batteries", R. Oldenbourg Verlag, Munich, Berlin, 1922.

(14) K.W. Schrick, "Applications of Kalman filtering", Oldenbourg Verlag, 1977.

(15) H. D. Luke, "Digital signal processing", Lecture, RWTH, Aachen, SS 1980.

(16) A. Weinmann, "Discrete Kalman filters and their calculation process", ELIN-Zeitschrift, No. 3/4, pp. 83-85, 1985.

(17) J. Melsa, D. Cohn. "Decision and estimation theory", McGraw-Hill Kogakusha, Tokyo, 1978.

(18) Arild Lacroix, "Digital filters: Introduction to discrete-time signals and systems", R. Oldenbourg, Munich-Vienna, 1980.

## Claims

1. A battery state of charge indicator for a vehicle starter battery including:

    a) means for periodically measuring the output voltage (u), the current (i) being withdrawn from or supplied to the battery, and the temperature ($\theta$) of the battery,

    b) battery current integrating means (22) for integrating the battery current (i) with respect to time to produce an indication of the net charge (q) taken from the battery;

    c) means (21,23) responsive to successive measured values of battery voltage (u), current (i) and temperature ($\theta$) and to the net charge (q) taken from the battery to predict the net charge ($q_e$) which can still be withdrawn from the battery;

    characterised by:

    d) means (33) for generating an indication of the gassing current ($i_g$) flowing inside the battery from the battery current (i); and

    e) means (24) for adding the gassing current ($i_g$) to the battery current (i) prior to integration thereof to correct for the effect of gassing current in the indication of withdrawn charge (q) taken from the battery and hence in the withdrawable charge ($q_e$) which can still be withdrawn from the battery.

2. A battery state of charge indicator as claimed in claim 1 characterised by :

    a) means for disabling the battery current integrating means (22) whenever the withdrawn charge (q) falls to zero; and

    b) overcharge current integrating means (29), enabled only when the withdrawn charge is zero, for producing an indication of the overcharge ($q_u$) supplied to the battery while in a fully charged state.

3. A battery state of charge indicator as claimed in claim 1 or claim 2 characterised in that the gassing current indicating means (33) is responsive to the voltage (u) and temperature ($\theta$) indications to calculate $i_g$ using the formula:

    $$i_g = i_{go}.e(u-ugo)/k\theta$$

    where:

    $u_{go}$    is the open circuit battery voltage

    k    is a constant

    $i_{go}$    is the gassing current in the rest condition.

4. A battery state of charge indicator as claimed in claim 3 characterised in that the gassing current indicating means (33) produces an estimate of the gassing current in the rest condition ($i_{go}$) from the difference between an estimated value ($i_z$) and the measured current (i) during the charging phase.

5. A battery state of charge indicator as claimed in any one of the preceding claims characterised in that the withdrawable charge predicting means (21,23) uses a two part mathematical model, the first part being a linear model which predicts internal battery quantities that vary linearly with measurable battery values and the second part predicts internal battery quantities that have a non-linear relationship to measurable values.

6. A battery state of charge indicator as claimed in claim 5 characterised in that the first part of the mathematical model is a recursive digital filter (21).

7. A battery state of charge indicator as claimed in claim 6 characterised in that the digital filter (21) is a Kalman filter.

8. A battery state of charge indicator as claimed in claim 6 or claim 7 characterised in that the predicted rest voltage $u_o$ is compared with a measured value of the actual rest voltage when the battery has been at rest for a predetermined period and the parameters of the mathematical model are adjusted to reduce the difference between the predicted and actual values.

9. A battery state of charge indicator as claimed in any one of the preceding claims characterised by means for generating a state of charge signal Iz derived from the withdrawable charge $q_e$ and the withdrawn charge q using the relationship:

$$Iz = (q_e - q)/q_e.$$

**Patentansprüche**

1. Batterie-Ladezustands-Anzeiger für eine Kraftfahrzeug-Starterbatterie, mit:
   a) Mitteln zur periodischen Messung der Ausgangsspannung (u), des der Batterie entzogenen oder zugeführten Stromes (i), und der Temperatur ($\theta$) der Batterie;
   b) Mitteln (22) zur Batteriestrom-Integration, zur Integration des Batteriestromes (i) in bezug auf die Zeit, zwecks Erstellung einer Anzeige der der Batterie entzogenen Nettoladung (q);
   c) Mitteln (21, 23), die auf die wiederholten Messungen der Werte für Batteriespannung (u), Strom (i) und Temperatur ($\theta$) und auf die der Batterie entzogene Nettoladung (q) so reagieren, daß sie die der Batterie noch entziehbare Nettoladung ($q_e$) vorhersagen; gekennzeichnet durch:
   d) Mittel (33) zur Bildung einer Anzeige des innerhalb der Batterie fließenden Gasungsstromes ($i_g$), ausgehend von dem Batteriestrom (i); und
   e) Mittel (24) zur Addierung des Gasungsstromes ($i_g$) zu dem Batteriestrom (i) vor der Integration desselben, zur Korrektur der Wirkung des Gasungsstromes auf die Anzeige des der Batterie entzogenen Stromes (q) und somit auf die der Batterie noch entziehbare Ladung ($q_e$).

2. Batterie-Ladezustands-Anzeiger nach Anspruch 1, gekennzeichnet durch:
   a) Mittel zur Außerbetriebsetzung der Batteriestrom-Integrationsmittel (22) sobald die entzogene Ladung (q) auf Null abfällt; und
   b) Überladestrom-Integrationsmittel (29), die nur dann in Betrieb gesetzt werden, wenn die entzogene Ladung gleich Null ist, zur Bildung einer Anzeige des der Batterie zugeführten Überladestroms ($q_u$), während diese sich in einem Zustand voller Ladung befindet.

3. Batterie-Ladezustands-Anzeiger nach Anspruch 1 oder 2, dadurch gekennzeichnet, daß die Mittel (33) zur Anzeige des Gasungsstroms auf die Anzeigewerte für Spannung (u) und Temperatur ($\theta$) so reagieren, daß sie $i_g$ nach folgender Formel berechnen:

$$i_g = i_{go} \bullet (u - u_{go})/k\theta$$

wobei:
   $u_{go}$     die Batteriespannung bei offenem Stromkreis ist,
   k     eine Konstante ist,
   $i_{go}$     der Gasungsstrom im Ruhezustand ist.

4. Batterie-Ladezustands-Anzeiger nach Anspruch 3, dadurch gekennzeichnet, daß die Mittel (33) zur Anzeige des Gasungsstroms eine Schätzung des Gasungsstroms im Ruhezustand ($i_{go}$) liefern, ausgehend von der Differenz zwischen einem geschätzten Wert ($i_z$) und dem während der Ladephase gemessenen Strom (i).

5. Batterie-Ladezustands-Anzeiger nach einem beliebigen der vorangehenden Ansprüche, dadurch gekennzeichnet, daß bei den Mittel (21, 23) zur Vorhersage der entziehbaren Ladung ein zweiteiliges

EP 0 376 967 B1

mathematisches Modell zum Einsatz kommt, wobei der erste Teil ein lineares Modell ist, welches interne Batteriemengen vorhersagt, die sich linear mit meßbaren Batteriewerten ändern, und wobei der zweite Teil interne Batteriemengen vorhersagt, die in einer nicht-linearen Beziehung zu meßbaren Werten stehen.

6. Batterie-Ladezustands-Anzeiger nach Anspruch 5, dadurch gekennzeichnet, daß der erste Teil des mathematischen Modells ein rekursiver Digitalfilter (21) ist.

7. Batterie-Ladezustands-Anzeiger nach Anspruch 6, dadurch gekennzeichnet, daß der Digitalfilter (21) ein Kalmanfilter ist.

8. Batterie-Ladezustands-Anzeiger nach Anspruch 6 oder Anspruch 7, dadurch gekennzeichnet, daß die vorhergesagte Restspannung ($u_o$) mit einem gemessenen Wert der tatsächlichen Restspannung verglichen wird, wenn die Batterie für eine bestimmte Zeit im Ruhezustand war, und daß die Parameter des mathematischen Modells zur Reduzierung der Differenz zwischen vorhergesagten und tatsächlichen Werten korrigiert werden.

9. Batterie-Ladezustands-Anzeiger nach einem beliebigen der vorangehenden Ansprüche, gekennzeichnet durch Mittel zur Erzeugung eines Ladungssignals ($I_z$), das abgeleitet ist aus der entziehbaren Ladung ($q_e$) und der entzogenen Ladung (q), und zwar nach folgender Beziehung:

$$I_z = (q_e - q)/q_e.$$

**Revendications**

1. Indicateur de charge d'une batterie de démarrage d'un véhicule, comprenant:
   a) des moyens destinés à mesurer de façon périodique la tension de sortie (u), le courant (i) tiré de la batterie ou alimentant celle-ci, et la température ($\theta$) de la batterie,
   b) des moyens (22) d'intégration du courant (i) de la batterie par rapport au temps, de manière à produire une indication de la charge nette (q) consommée de la batterie;
   c) des moyens (21, 23) réagissant aux valeurs obtenues par les mesures successives de la tension (u) de la batterie, du courant (i) et de la température ($\theta$), et à la charge nette consommée de la batterie, de manière à prédire la charge nette ($q_e$) qui peut encore être tirée de la batterie;
   caractérisé par:
   d) des moyens (33) destinés à générer une indication du courant de bouillonnement ($i_g$) circulant dans la batterie, à partir du courant (i) de la batterie; et
   e) des moyens (24) destinés à additionner le courant ($i_g$) de bouillonnement et le courant (i) de la batterie avant intégration de celui-ci, afin de corriger l'effet que produit le courant de bouillonnement sur l'indication de la charge consommée (q), tirée de la batterie et, par conséquent, sur l'indication de la charge ($q_e$) à tirer, qui peut encore être tirée de la batterie.

2. Indicateur de charge de batterie selon la revendication 1, caractérisé par:
   a) des moyens destinés à mettre hors service les moyens (22) d'intégration du courant de batterie dès que la charge consommée (q) tombe à zéro, et
   b) des moyens (29) d'intégration de courant de surcharge, mis en service uniquement lorsque la charge consommée est nulle, destinés à produire une indication de la surcharge ($q_u$) fournie à la batterie lorsque celle-ci est pleinement chargée.

3. Indicateur de charge de batterie selon l'une des revendications 1 ou 2, caractérisé en ce que les moyens indicateurs (33) du courant de bouillonnement réagissent aux indications de tension (u) et de température ($\theta$) pour calculer $i_g$ selon la formule suivante:

$$i_g = i_{go} \bullet e\ (u - u_{go})/k\theta$$

où:
   $u_{go}$      est la tension de la batterie à circuit ouvert
   k         est une constante
   $i_{go}$      est le courant de bouillonnement aux conditions de repos.

14

**4.** Indicateur de charge de batterie selon la revendication 3, caractérisé en ce que les moyens indicateurs (33) du courant de bouillonnement produisent une estimation du courant de bouillonnement existant dans des conditions de repos ($i_{go}$),à partir de la différence entre une valeur estimée ($i_z$) et le courant (i) mesuré pendant la phase de chargement.

**5.** Indicateur de charge de batterie selon l'une quelconque des revendications précédentes, caractérisé en ce que les moyens (21, 23) de prévision de la charge pouvant être tirée utilisent un modèle mathématique en deux parties, la première partie étant un modèle linéaire, qui prédit les quantités internes de la batterie, qui varient de façon linéaire en même temps que des valeurs mesurables de la batterie, et la seconde partie prédisant les quantités internes de la batterie, qui présentent une relation non linéaire par rapport aux valeurs mesurables.

**6.** Indicateur de charge de batterie selon la revendication 5, caractérisé en ce que la première partie du modèle mathématique est un filtre numérique récursif (21).

**7.** Indicateur de charge de batterie selon la revendication 6, caractérisé en ce que le filtre numérique (21) est un filtre Kalman.

**8.** Indicateur de charge de batterie selon la revendication 6 ou la revendication 7, caractérisé en ce que la tension restante prévisionnelle ($u_o$) est comparée avec une valeur mesurée de la tension restante réelle, lorsque la batterie a été au repos pendant une période prédéterminée, et en ce que les paramètres du modèle mathématique sont réajustés de manière à réduire la différence entre les valeurs prévisionnelles et les valeurs réelles.

**9.** Indicateur de charge selon l'une quelconque des revendications précédentes, caractérisé par des moyens destinés à générer un signal ($I_z$) de l'état de charge, qui est dérivé de la charge ($q_e$) pouvant être tirée et de la charge consommée (q), selon la relation suivante:

$$I_z = (q_e - q)/q_e.$$

15

FIG.1.

FIG.2.

FIG.3.

FIG.4.

FIG.5.

FIG.6.

FIG.7.

FIG.8.

FIG.9.

FIG.10.

FIG.11.

FIG.12.